## Europäisches Patentamt
## European Patent Office
## Office européen des brevets

(11) Publication number: **0 114 998**
**B1**

## EUROPEAN PATENT SPECIFICATION

(45) Date of publication of patent specification: **07.06.89**

(51) Int. Cl.⁴: **G 06 F 11/00**

(21) Application number: **83112634.7**

(22) Date of filing: **15.12.83**

---

(54) Serial keyboard interface system.

---

(30) Priority: **28.12.82 JP 227846/82**
**11.03.83 JP 39326/83**

(43) Date of publication of application:
**08.08.84 Bulletin 84/32**

(45) Publication of the grant of the patent:
**07.06.89 Bulletin 89/23**

(84) Designated Contracting States:
**BE DE FR GB IT NL**

(56) References cited:
**EP-A-0 071 747**
**US-A-3 483 510**
**US-A-3 696 338**

**WIRELESS WORLD, vol. 87, no. 1545, June
1981, pages 77-78, Sheepen Place, Colchester,
GB; M.D. ALGER et al.: "Remote keyboard
interface"**

**PATENTS ABSTRACTS OF JAPAN, vol. 6, no.
148 (P-133)1026r 7th August 1982; & JP-A-57
69 435**

**IBM TECHNICAL DISCLOSURE BULLETIN, vol.
18, no. 8, January 1976, Seiten 2409-2410, New
York, US; G.A. BIGELOW: "Data clocking"**

(73) Proprietor: **International Business Machines
Corporation
Old Orchard Road
Armonk, N.Y. 10504 (US)**

(72) Inventor: **Tajima, Satoshi
Kamiwada-danchi 1-3-501 2412 Kamiwada
Yamato-shi Kanagawa-Ken (JP)**
Inventor: **Watanabe, Shinpei
Matsuai-manshion 305 139 Nishimatano
Fujisawa-shi Kanagawa-Ken (JP)**
Inventor: **Suzuki, Toshio
157 Saitobuncho Kanagawa-ku
Yokohama-shi Kanagawa-Ken (JP)**
Inventor: **Yanagi, Tsutomu
Hario-Apartment 201 9-23 Fujigaya 1-chome
Kugenuma Fujisawa-shi Kanagawa-Ken (JP)**
Inventor: **Yonemochi, Kenshin
15-12 Honcho 3-chome
Fujisawa-shi Kanagawa-Ken (JP)**

(74) Representative: **Rudolph, Wolfgang, Dipl.-Ing.
IBM Deutschland GmbH Schönaicher Strasse
220
D-7030 Böblingen (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a keyboard interface, and more particularly to a serial keyboard interface system to prevent the erroneous transmission of keyboard data due to noise in a data processing system wherein a keyboard and a data processing unit are connected through a clock line for transmitting a keyboard clock signal and a data line for transmitting a serial scan code identifying a key, said scan code being transmitted in a frame including a predetermined number of bits and in synchronism with said clock signal.

In EP-A-71 747 a keyboard system is proposed in which a keyboard and a data processing unit are connected through a data line and a clock line so as to transmit keyboard out codes bit-serially through the data line and to transmit a keyboard out clock signal through the clock line. The keyboard out codes are transmitted in a 9-bit frame consisting of a leading start bit and the following 8-bit serial scan code identifying a key position. On the data processing unit side, there is provided a 9-stage serial-parallel shift register connected to the data line and clock line. The bits of the frame received are loaded successively from lowest ordered or least significant stage of the serial-parallel shift register under the control of the clock signal. The completion of the receipt of the 9-bit frame is indicated when the start bit appears at the highest ordered or most significant stage.

The start bit from the highest ordered stage causes an interruption to request the read-in of the scan code in the shift register into the data processing unit, and also signals to the keyboard that the keyboard data cannot be sent until the read-in process is completed.

This keyboard system is very simple because the keyboard data can be sent by the use of a single data line and a single clock line, and further the keyboard has the advantage of being operated at the pace of its own clock independently of the clock of the data processing unit.

It was found, however, that this keyboard causes false operation due to noise when a low cost stretch cable without shield is used as a cable for connecting the keyboard with the data processing unit for economical reason. Static discharge typical of external disturbance causes noise pulse on the cable. The noise pulse may be induced on both the data and clock lines. When the data signal is sampled in response to the transitions of the clock signal for loading into the shift register, a bit error may be caused if the noise pulse on the data line is sampled. However, this bit error may be detected, for example, by parity check.

On the other hand, in case the noise pulse is induced on the clock line, the same data bit is sampled twice by the normal clock signal and the noise pulse. This leads to false receipt of 9 bits of a frame by the serial-parallel shift register before the 9-bit transmission from the keyboard is completed, resulting in drop out of the 9th bit. Since the number of binary 1's is unchanged when the last bit dropped out is binary 0 and the data bit sampled twice is binary 0 and when the last bit is binary 1 and the data bit sampled twice is binary 1, this data error cannot be detected by parity check. The data error is also caused when clock pulses are counted in response to the transitions of the clock signal until a predetermined number of bits of a frame is reached, which indicates the end of a frame. In this case, counting is made twice in one clock cycle due to noise, causing similar erroneous transmission.

Although such data error due to noise pulses may be prevented by the use of a shielded cable, but such a cable is very expensive and it is desired to prevent such data error with a low cost cable without shield.

Therefore, the object of the present invention is to provide a serial keyboard interface system for a data processing system of the type in which a keyboard and a data processing unit are connected through a clock line and a data line for transmitting keyboard data serially, which solves the problem of erroneous transmission of keyboard data due to noise pulses induced on the clock line.

The keyboard interface system of the present invention is arranged in accordance with claim 1.

In accordance with an embodiment of the serial keyboard interface system of the present invention, check is made between the keyboard and the data processing unit as to whether or not the data are correctly transmitted to the data processing unit side. On the data processing unit side, counting is made in response to the clock signal, and when the number equal to a predetermined number of bits of a frame is counted, a status signal indicating the receipt of the keyboard data bits of a frame is returned to the keyboard. This status signal is transmitted through the data line. On the keyboard side, check is made as to whether or not the status signal is returned after the transmission of data bits of a frame is completed, and when the status signal is received before the completion of transmission, a negative response signal is transmitted to the data processing unit side, and when the status signal is received after the completion of transmission a positive response signal is transmitted. These response signals may be transmitted through the data line or the clock line. In case of negative response, the data previously received is discarded in the data processing unit, and the keyboard retransmits the same keyboard data. The present invention may be implemented with dedicated hardware or microprocessors.

The advantage of this solution is the use of low cost cables without shield.

The foregoing and other objectives, features and advantages of the subject invention will best be understood from the following description when read in conjunction with the accompanying drawings.

Fig. 1 shows the first embodiment of the present invention implemented by hardware, configured to supply the positive/negative response to the data line;

Fig. 2 shows the waveforms of the operation;

Fig. 3 shows the second embodiment of the present invention using microprocessors;

Figs. 4A through 4C show the control program flowchart of the microprocessors of Fig. 3 when the positive/negative response is supplied to the data line;

Fig. 5 is a block diagram showing a third embodiment of this invention;

Fig. 6 shows a fourth embodiment of this invention;

Figs. 7A and 7B show operational waveforms illustrating correct transmission and erroneous transmission, respectively; and

Fig. 8 is a program flowchart for the embodiment in Fig. 6.

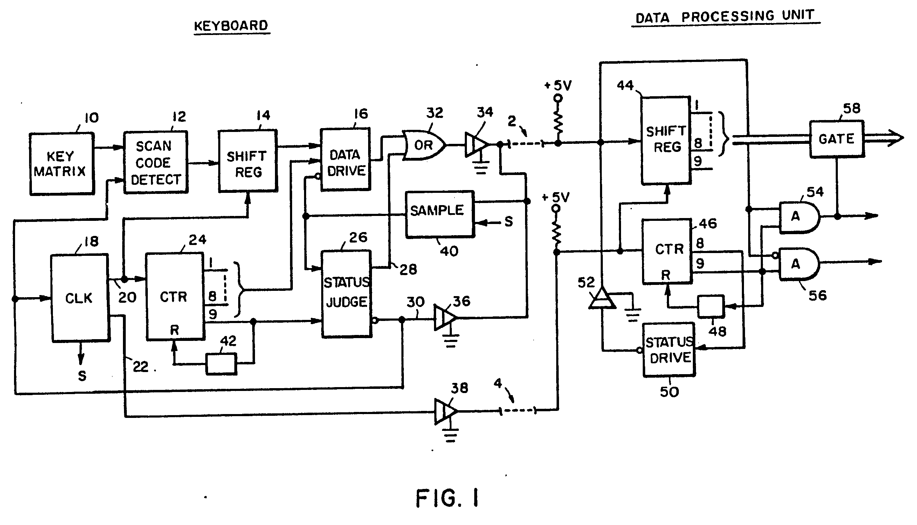

Referring to the drawings, the preferred embodiments of the present invention will be described. Fig. 1 shows the configuration of a first embodiment implemented by hardware, and the left side of Fig. 1 shows the keyboard side, and the right side shows the data processing unit side. The keyboard and the data processing unit are connected through a data line 2 and a clock line 4. The depression of a key in a key matrix 10 is detected by a key scan code detection circuit 12, and the 8-bit scan code identifying the key depressed is held in a code register in the key scan code detection circuit 12, then loaded into the serial-parallel shift register 14. A clock circuit 18 generates 9 clock pulses on a line 20 each time a scan code is transmitted. The shift register 14 shifts out the 8-bit scan code serially to a data drive circuit 16 in response to the clock pulses on the line 20. A counter 24 counts 9 clock pulses on the line 20. The count outputs 1-8 are sent to the data drive circuit 16. The count 9 output is applied to a status judge circuit 26.

The status judge circuit 26 receives the output of a sample circuit 40 as another input. The sample circuit 40 receives the data line 2 as an input, and receives sample pulses S as another input, which are produced by the clock circuit 18 in each clock cycle at a predetermined timing. The data processing unit applies to the data line 2 a low level status signal indicating the completion of receipt of the keyboard data of a frame when the keyboard data of a frame is received. The sample circuit 40 checks at each sample time if the status signal is supplied to the data line 2 from the data processing unit, and produces a high level output when the status signal is detected.

The status judge circuit 26 is responsive to the count 9 output of the counter 24 and the output of the sample circuit 40 to judge if the status signal is detected in the period of the count 9. The status judge circuit 26 produces a high level output indicative of positive response on the line 28 when the status signal is detected in the period of the count 9, and when the status signal is not detected in the period of the count 9, it produces a low level signal indicative of negative response on the line 30.

The output of the sample circuit 40 is applied to the data drive circuit 16. The data drive circuit 16 receives the serial 8-bit scan code from the shift register 14, the count outputs 1-8 of the counter 24 and the output of the sample circuit 40, and on condition that the output of the sample circuit 40 is low, i.e., the status signal is not detected, the data drive circuit 16 sends the 8-bit data of the scan code serially in synchronism with the count outputs 1-8. The output of the data drive circuit 16 drives an open collector gate 34 through an OR circuit 32. The data line 2 is connected to +5V power supply and is normally at high level. The open collector gate 34 acts to maintain the high level of the data line 2 when the input (the output of the OR circuit 32) is high, and to lower the level of the data line to low level (typically earth level) when the input is low. For example, such an open collector gate is shown as SN 7407 in Texas Instruments' "The TTL Data Book", second edition, 1976. Thus, the data drive circuit 16 outputs scan code bits to the data line 2 until the status signal is detected by the sample circuit 40. In this example, it is assumed that the keyboard data of a frame contains only an 8-bit scan code.

On the other hand, the clock circuit 18 generates 9 clock pulses on a line 22 each time a scan code is transmitted, and drives the clock line 4 through an open collector gate 38. The clock line 4 is also connected to +5V power supply, and is normally at high level. The clock signal on the line 22 has the same frequency as that of the clock signal on the line 20 but is delayed by a predetermined time from the clock signal on the line 20 so that the data signal on the data line 2 and the clock signal on the clock line 4 are in a predetermined phase relationship.

On the data processing unit side, the serial data bits are loaded into a 9-stage serial-parallel shift register 44 by the clock signal on the clock line 4, and clock pulses are counted by the counter 46. When the count reaches 8, which shows the completion of receipt of the 8-bit scan code of a frame, a status drive circuit 50 produces a low level in response to the count 8 output of the counter 46, and drives the data line 2 to low level through an open collector gate 52. This low level of the data line 2 is the status signal indicative of the completion of receipt of a frame.

The status signal is detected by the sample circuit 40, and supplied to the status judge circuit 26. The status judge circuit 26 produces a high level output on the line 28 when the status signal is detected in the period of count 9 of the counter 24, drives the data line 2 to high level through the OR circuit 32 and the open collector gate 34, providing a positive response signal. The status judge circuit 26 produces a low level output on the line 30 when the status signal is not detected in the period of count 9, and drives the data line 2 to low level through the open collector gate 36, providing a negative response signal.

The count 9 output of the counter 46 is applied to one input of the AND circuits 54 and 56, and the data line 2 is connected to another input of the AND circuits 54 and 56. The AND circuit 54 produces an output when the level of the data line 2 is high at count 9, i.e., positive response, indicating correct receiving. The output of the AND circuit 54 activates the gate circuit 58 to gate the bits 1-8 of the serial-parallel register 44 to other processing part in the data processing unit. The AND circuit 56 produces an output when the level of the data line is low at count 9, i.e., negative response, indicating incorrect receiving. The output of the AND circuit, if required, may be used to signal "stand by" to other processing part.

The low level negative response signal on the line 30 from the status judge circuit 26 is sent to the clock circuit 18 and the key scan code detection circuit 12 to initialize these circuits, and commands the retransmission of the same keyboard data in the code register of the circuit 12. The counters 24 and 46 are reset by their count 9 outputs passing through the delay circuits 42 and 48, respectively.

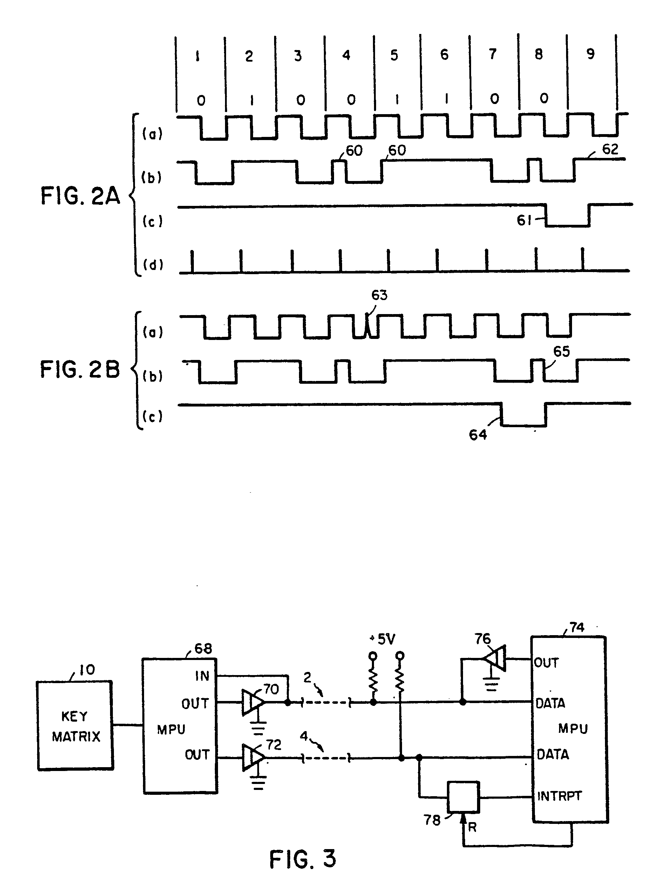

Next, referring to waveforms in Fig. 2 illustrating operational examples of the present invention, the operation of the keyboard interface system of Fig. 1 will be described. Fig. 2A shows correct data transmission and Fig. 2B shows erroneous data transmission. First, in Fig. 2A, the waveform (a) shows the clock signal to the clock line 4 from the clock circuit 18 through the line 22 and the open collector gate 38. In the example, the high and low level periods of the clock signal are 100 us, respectively. The waveform (b) shows the data signal to the data line 2 from the keyboard. The waveform (c) shows the status signal to the data line 2 from the data processing unit side. In Fig. 2A, although waveforms (b) and (c) are separately shown for convenience, the voltage level of the data line is actually a logical AND of waveforms (b) and (c). The numbers 1-7 at the upper most row show the clock cycles, and data of a frame ends at the cycle 8 and the cycle 9 is used for status detection/response.

In the keyboard, the data line 2 is sampled in the sample circuit 40 by the sample pulse S from the clock circuit 18 for each clock cycle and the presence of the status signal is checked. The waveform (d) shows the sampling time by the sample pulses S. The status signal is of low level, and in order to enable the detection of the status signal of low level, it is required for the keyboard to make the level of the data line high at the sampling time. Therefore, the data signal is, as indicated by the reference number 60, driven to high for a predetermined period including the sampling time regardless of the value of data bit.

The transitions of the clock signal (a) to low level are counted with the counter 46. Also, the data signal (b) is sampled at the transitions of the clock signal (a) to low level, and is loaded into the shift register 44. Therefore, it is required for the data signal to have a significant data level at the time of the transitions of the clock signal (a) to low level. Therefore, the signal (a) is delayed from the clock signal on the line 20 so as to provide this phase relation.

On the keyboard, the data line is sampled at each clock cycle, and since the status signal is not detected before cycle 7, the keyboard continues to send serial data bits. At cycle 8, the counter 46 produces count 8 output and makes the data line level low as 61 of the waveform (c), thereby returning to the keyboard the status signal indicative of the completion of receiving of a frame.

Since the sampling circuit 40 detects the low level of the status signal at the sampling of cycle 9 and this time the counter 24 counts 9, the status judge circuit 26 drives the data line through the line 28 to high level (62 of the waveform b), thereby returning the positive response signal to the data processing unit.

The counter 46 of the data processing unit produces count 9 output at the negative-going transition of the clock pulse of cycle 9, when the AND circuit 54 produces an output in response to the positive response signal and count 9.

Fig. 2B shows the case where erroneous transmission is caused by noise pulse 63. During clock cycle 4, the shift register 44 of the data processing unit samples the data bit 0 twice at the negative-going transitions of the clock pulse and the noise pulse 63, and takes in the same data twice. therefore, data error is caused. Since the counter 46 also counts twice at the negative-going transitions of the clock pulse of clock cycle 4 and the noise pulse 63, the counter 46 produces count 8 output at clock cycle 7, and the status signal is produced at clock cycle 7 as 64 of the waveform (c).

On the keyboard, the status signal is detected at the sampling of clock cycle 8. At this time, since the counter 24 does not produce count 9 output, the status judge circuit 26 drives the data line through the line 30 to low level (65 of the waveform b), thereby providing the negative response signal.

On the data processing unit, the counter 46 produces count 9 output at the clock pulse of clock cycle 8, and the AND circuit 56 produces an output.

The negative response signal from the status judge circuit 26 is transferred to the clock circuit 18 and the key scan code detection circuit 12 to control them to retransmit the keyboard data.

The duration of the noise pulse due to static discharge is on the order of 10-100 ns, and experience shows that noise pulses are produced at time intervals of at least 10 ms. These intervals are considerably longer than the time required for (the transmission of a frame) plus (status detection/response/retransmission) when a clock cycle is 200 µs as in this example, and it was found that it is rarely that erroneous transmission is again detected in retransmission and that retransmission is not repeated. Since the intervals of noise pulses may change depending on circumstances, the clock frequency should be chosen according to the possible intervals of noise pulses.

The functions described above such as keyboard data transmission, the return of status information, the detection of status information, positive/negative response and retransmission can be implemented with microprocessors and microcodes. Fig. 3 shows another embodiment of the present invention for the case. The keyboard comprises a key matrix 10, a microprocessor 68, open collector gates 70 and 72, and the data processing unit comprises a microprocessor 74, an open collector gate 76 and an interruption latch 78. The gate 70 corresponds to the open collector gates 34 and 36 in Fig. 1, the gate 72 corresponds to the open collector gate 38 in Fig. 1, and the gate 76 corresponds to the gate 52 in Fig. 1. Therefore, all other functional means of the keyboard in Fig. 1 than the key matrix 10, and gates 34, 36 and 38 are performed by the microprocessor 68. Functional means of the data processing unit in Fig. 1 other than the gate 52 are performed by the microprocessor 74 and the interruption latch 78.

The microprocessor 68 is a microprocessor such as Intel 8048, and constitutes a self-scan serial keyboard together with the key matrix 10. The microprocessor 74 is a microprocessor such as Motorola 6800. Functions performed by the microprocessors 68 and 74 correspond to functions described above relating to Figs. 1 and 2. A feature in operation based on the use of program control is the use of interruption. In Fig. 1, data bits are automatically taken in the serial-parallel register 44 in response to the negative-going transitions of the clock signal, and the negative-going transitions of the clock signal are counted with the counter 46. On the other hand, in the example of Fig. 3, the keyboard interruption request is issued to the microprocessor 74 by the latch 78 set based on the negative-going transition of the clock signal, and by this interruption, the data signal sampling and bit counting are initiated. At the end of operations such as data sampling and bit counting, the latch 78 is reset, and the microprocessor 78 returns to the data processing before the interruption, and continues the data processing until the keyboard interruption request is issued again by the low level of the clock signal at next clock cycle.

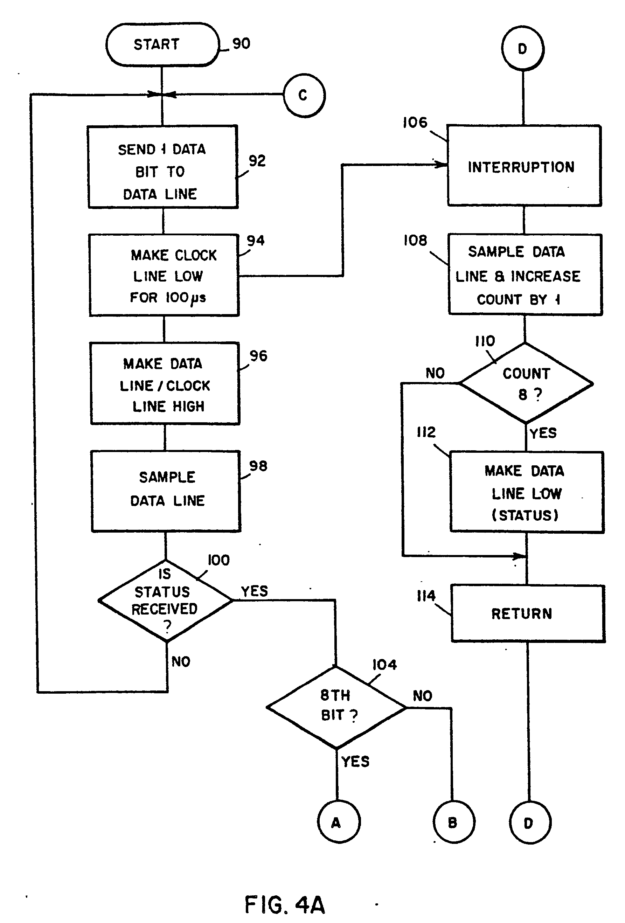

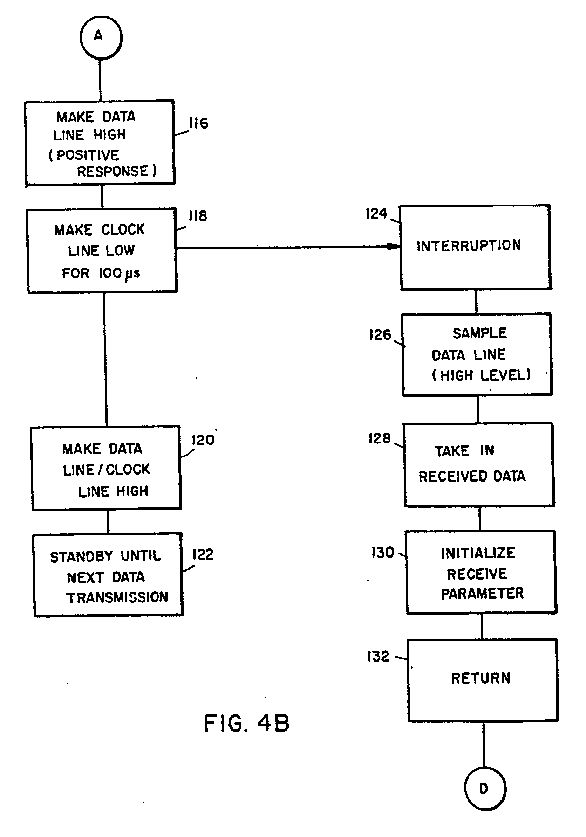

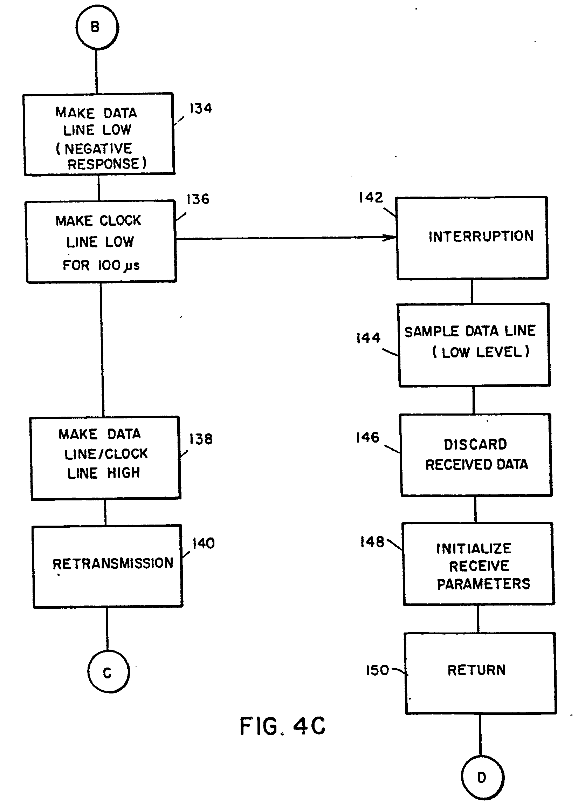

Figs. 4A, 4B and 4C are a flowchart of the control program for performing the above functions in the system of Fig. 3. On the keyboard side, the operation is started at step 90, and the first bit of the keyboard data of a frame is applied to the data line 2 at step 92. This corresponds to the negative-going transition in clock cycle 1 of the waveform (b) in Fig. 2A. At step 94, the level of the clock line 4 is made low for 100 μs. This corresponds to the low level in clock cycle 1 of the waveform (a) in Fig. 2A. At step 96, the data line and the clock line are made high. The clock line is made high at the end of each clock cycle. Also, to enable data line sampling for the status signal, the the data line needs to be made high in the first half of each clock cycle regardless of the value of data bit. At step 98, the data line is sampled. At step 100, check is made as to whether the status signal is detected as the result of sampling.

If the status signal is not detected at step 100, the program returns to step 92 and the operation is repeated. This corresponds to the transmission of data bits based on count outputs 1-8 of the counter 24 in Fig. 1 unless the status signal is detected in the sampling circuit 40. If the status signal is detected at step 100, the program proceeds to step 104 where check is made as to whether the status signal is detected as the result of the transmission of the 8th data bit. If YES, the program proceeds to A (Fig. 4B), and if NO, the program proceeds to B (Fig. 4C).

On the other hand, on the data processing unit, the latch 78 is set by the negative-going transition of the clock line at step 94 to issue keyboard interruption request. By this, the data line 2 is immediately sampled early in the low level period of the clock signal, and the count of the received data bit is increased by 1. At step 110, whether the data bit count is 8 is checked. If the count is not 8, the program proceeds to step 114, and the program return operation is performed. That is, the microprocessor 74 returns to the program processing before the interruption, and continue the processing until next keyboard interruption. If count = 8 is detected at step 110, the program proceeds to step 112 to make the data line low to send the status signal, then proceeds to the return operation of step 114.

If the status signal is detected after the transmission of the 8th bit, the program proceeds from step 104 to Fig. 4B, and the keyboard drives the data line to high level at step 116, providing the positive response signal (62 of the waveform b on Fig. 2A). Then, the level of the clock line is made low for 100 μs.

In the data processing unit, keyboard interruption is produced at step 124 by the low level of the clock line at step 118, and the data line is sampled at step 126. Since the high level is detected at this time, showing correct receiving, the received scan code is taken in at step 128, the receiving parameters are initialized in preparation for receiving of next keyboard data at step 130, and the return operation is entered at step 132.

The keyboard makes the clock line level high after 100 μs of the low level period and makes the data line high at step 120, and waits until the transmission of next keyboard data at step 122.

When a noise pulse is produced on the clock line, interruption is caused also by the noise pulse, and data sampling and bit counting are performed twice for the same bit. Therefore, before the keyboard transmits the 8th bit, the bit count becomes 8 in the data processing unit. In this case, therefore, the answer to step 104 on Fig. 4A becomes NO and the program proceeds to Fig. 4C.

The keyboard drives the data line to low level at step 134, providing the negative response signal (65 of the waveform b on Fig. 2B). Next, the level of the clock line is made low for 100 μs at step 136.

The data processing unit produces interruption at step 142 by the low level of the clock line at step 136, and samples the data line at step 144. Since the low level is detected at this time, it shows incorrect receiving, the received scan code is discarded at step 146, the receiving parameters are initialized in preparation for retransmission at step 148, and the return operation is started at step 150.

The keyboard makes the clock line level high after 100 μs of the low level period at step 138 and makes the data line level high, and starts retransmission at step 140.

Although the data line is used for the transmission of positive/negative response in the above description, the clock line may also be used.

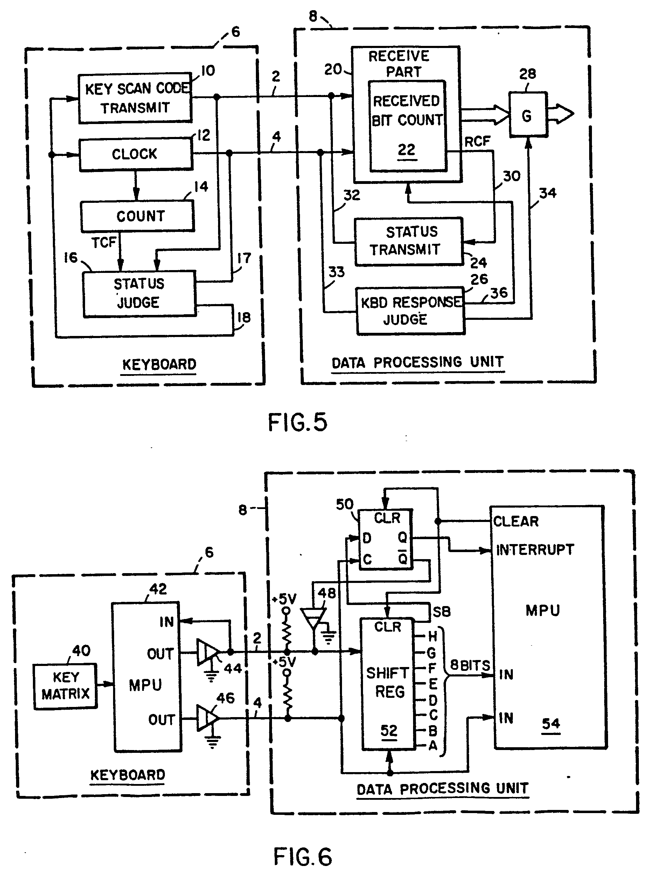

Fig. 5 is a block diagram showing a third embodiment of the invention. A broken line block 6 shows a keyboard, a broken line block 8 a data processing unit. The keyboard 6 is connected to the data processing unit 8 by one data line 2 and one clock line 4. A key scan code transmitting means 10 transmits a scan out code to the data line 2 bit-serially in the form of a frame including a scan code representing a depressed key. For example, a frame consists of a leading start bit and the following scan code bits identifying a key position. A clock means 12 transmits one clock pulse for each bit to the clock line 4 in synchronism with the transmission of serial frame bits. A counting means 14 counts clock pulses transmitted to the clock line 4. Therefore, the counting means 14 counts the number of serial bits transmitted. The counting means 14 generates a transmission count full signal TCF to a status judging means 16 when it counts the number equal to a predetermined number of bits for one frame.

On the other hand, the serial bits and the clock pulses transmitted from the keyboard 6 are applied to a receiving part 20 of the data processing unit 8, the received bit counting means 22 of which counts the number of received bits in response to each clock pulse on the clock line 4, and generates a receive count full signal RCF to a status transmitting means 24 through a line 30 when it counts the number equal to the number of bits for one frame. The status transmitting means 24 is responsive to the signal RCF on the line 30 to apply a status signal to the data line 2 through a line 32, which is indicative of the completion of receiving of serial bits in one frame.

The status judging means 16 of the keyboard 6 judges whether or not the status signal is returned to the keyboard after the completion of transmission of all the bits for one frame, that is, after the generation of the transmission count full signal TCF from the counting means 14. The status judging means 16 generates a positive response signal to the clock line 4 through a line 17 when the status signal is returned after the transmission of one frame is completed.

A keyboard response judging means 26 of the data processing unit checks the clock line 4 through a line 33 to judge whether the response from the keyboard is a positive or negative response. When the keyboard response judging means 26 detects the positive response, it activates a gate means 28 via a line 34 to cause the received data bits to be transferred to other processing part (not shown) of the data processing unit 8.

When a noise pulse occurs on the clock line 4 during the transmission of keyboard data, the received bit counting means 22 counts twice in one clock cycle, and generates the receive count full signal RCF before the completion of receiving of all the bits of one frame.

At that time, the status judging means 16 does not receive the transmission count full signal TCF when receiving the status signal. Therefore, it supplies a negative response signal to the clock line 4 through the line 17 and also supplies a control signal through a line 18 to the key scan code transmitting means 10 and the clock means 12 so as to command retransmission of the same scan code. When the keyboard response judging means 26 detects the negative response, it generates a signal to the receiving part 20 through a line 36 to discard the received data in preparation for retransmission.

Now, referring to Figs. 6-8, description is made on a fourth embodiment of the invention. Fig. 6 shows the embodiment which uses a microprocessor in each of the keyboard 6 and the data processing unit 8. The keyboard 6 comprises a key matrix 40, a microprocessor (MPU) 42, and open collector gates 44 and 46, while the data processing unit 8 comprises an open collector gate 48, a D-type edge trigger latch 50, a shift register 52, and a microprocessor (MPU) 54. The data line 2 and the clock line 4 are connected to +5V power supply through resistors respectively.

MPU 42 is a microprocessor, and constitutes a programmable self-scan serial keyboard in combination with the key matrix 40. The open collector gates 44, 46 and 48 act to provide high level output for high level input, and low level output (typically ground level) for low level input. The open collector gate is shown, for example, as SN 7407 in "The TTL Data Book" second edition, 1976, published by Texas Instruments Inc.

MPU 42 drives the data line 2 through the open collector gate 44, and the clock line 4 through the open collector gate 46. The data line 2 is also connected to an input terminal of MPU 42 so as to sample this line.

The data line 2 and the clock lines are connected to the shift register 52. It samples the data signal at the falling edge of each clock pulse, and takes in bits of one frame while sequentially shifting from the lowest ordered stage. In this embodiment one frame consists of a leading start bit SB, and the succeeding 8-bit scan code identifying a key position. The highest ordered stage of the shift register 52 is connected to the D input of the latch 50. The clock C input of the latch 50 is connected to the clock line 4.

When the start bit appears from the highest ordered stage of the shift register 52, the latch 50 is set at the falling edge of the clock pulse so as to make Q output high level and Q̄ output low level. The Q̄ output of low level drives the output of the open collector gate 48 to the low level (ground level), and thus makes the data line 2 low level. This low level on the data line becomes the status signal indicating the completion of receiving of one frame. Because the data line 2 is clamped at the ground level while the latch is being set, the keyboard can not transmit the data signal any longer.

The high level Q output of the latch 50 issues an interruption request to MPU 54, and invokes program steps to perform the required processes such as judgement of a keyboard response to the status signal. When MPU 42 returns the high level positive response signal via the clock line 4 as keyboard response, MPU 54 takes in the 8 scan code bits A-H of the shift register, clears or resets the latch 50 and the shift register 52, and returns to the programm process before the interruption.

When the latch 50 is cleared, the Q output becomes high level, and the open collector gate 48 maintains the data line 2 at high level (+5V). The high level state of the data line is detected by MPU 42, which indicates that new frame data can be transmitted from the keyboard.

When the low level negative response signal appears on the clock line 4 from MPU 42, MPU 54 clears the latch 50 and the shift register 52 without taking in the data of the register 52, and returns to the program process before the interruption.

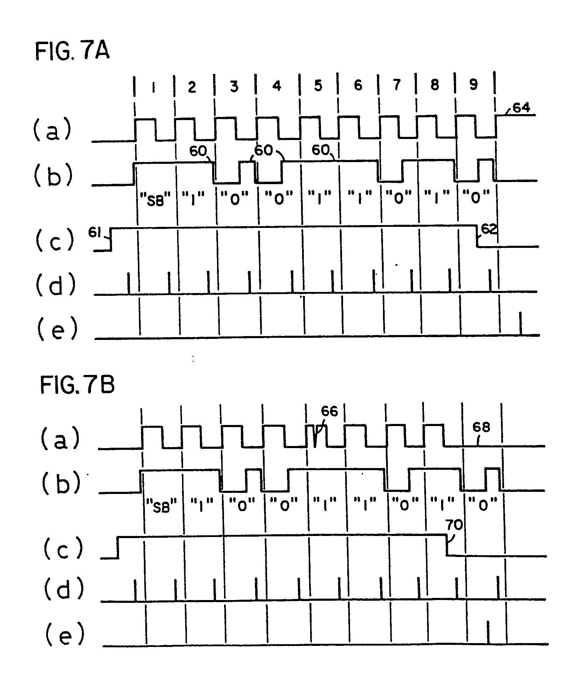

Figures 7A and 7B illustrates operational waveforms for correct and erroneous keyboard data transmission, respectively. In Figures 7A and 7B, the waveform (a) shows the clock pulses transmitted to the clock line 4, the waveform (b) the data signal transmitted to the data line 2, the waveform (c) the signal applied to the data line from the Q output of the latch 50 through the open collector gate 48, the waveform (d) the sample timing for MPU 42 to sample the data line 2, and the waveform (e) the sample timing for MPU 54 to sample the clock line 4 after the interruption.

In Figure 7A, when MPU 54 becomes possible to receive the keyboard data, MPU 54 clears or resets the latch 50 to make the data line 2 high level as indicated by 61 of the waveform (c). MPU 42 samples the data line 2 to check whether it is at high level (step 78 of the program flowchart in Figure 4). After confirming that the data line 2 is at high level, the data transmitting operation is initiated.

MPU 42 transmits frame bits consisting of (a leading start bit SB) plus (the succeeding 8-bit scan code), to the data line 2 bit-serially. Although preferred values for the high level and the low level intervals of the clock signal (a) are 50 μs - 100 μs and 25 μs - 50 μs respectively, each is set at 50 μs is this embodiment. However, these values are not important.

The data signal (b) is sampled and taken in at the falling edge of each clock pulse (a) in the shift register 52. Therefore, the data signal (b) needs to have significant data level at least at the time of the falling edge of each clock pulse. While, in this embodiment, each bit is arranged to have set-up and hold time of 2.5 μs with respect to the rising and falling edges of each clock pulse it is important when sampling at the falling edge that the significant data level is assured at the falling edge of each clock pulse.

In addition, MPU 42 is required to make the data line high level at least when sampling that line in order to detect the status signal from the data processing unit. If MPU 42 drives the data line 2 to low level (ground level) when sampling, the data line 2 is clamped, making it unable to detect the Q output status of the latch 50 correctly. Therefore, as indicated by 60 in the waveform (b), MPU 42 makes the data line 2 high level for a predetermined interval in the latter half of each clock cycle regardless of the bit transmitted being "1" or "0", MPU 42 sampling the data line 2 during said high level interval. In this embodiment, the data line level is made high after 2.5 μs elaspes from the falling edge of each clock pulse. Although, in the figure, the data signal (b) and the Q output (c) of the latch 50 are separately shown for convenience, logical AND of the waveform (b) and the waveform (c) appears on the data line 2.

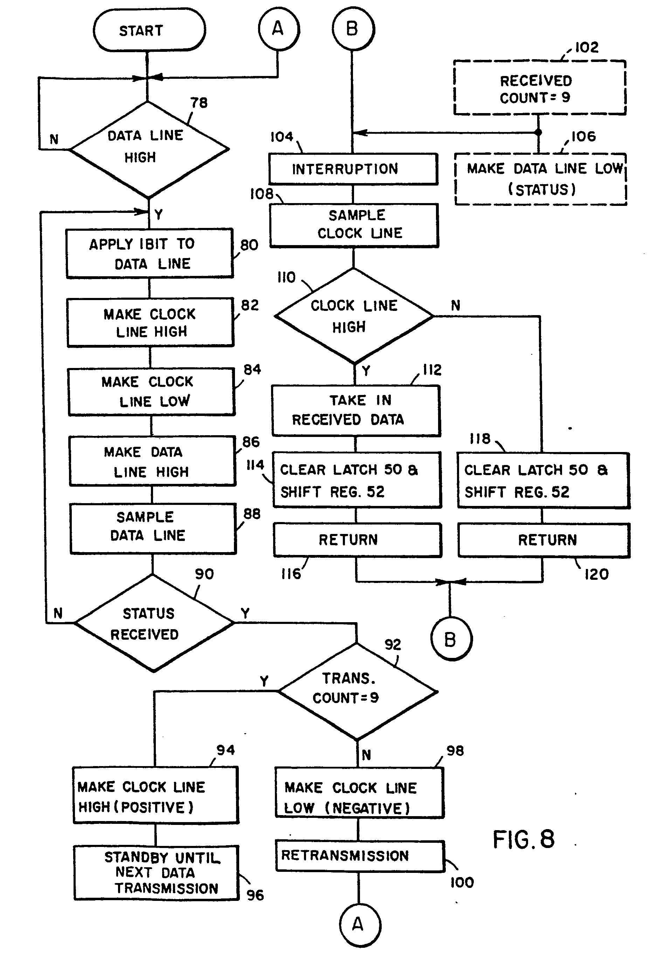

Therefore, when MPU 42 confirms the high level on the data line in the step 78 of the program steps in Figure 8, it applies one bit (first, the start bit SB) to the data line 2 (step 80 in Figure 8), and makes the clock line 4 high level after 2.5 μs from the rising edge of the start bit SB (step 82), the clock line 4 low level (step 84), and the data line 2 high level after 2.5 μs from the falling edge of the clock pulse (step 86). MPU 42 samples the data line 2 for each clock cycle (step 88) to check whether the status signal is sent from the data processing unit (step 90). If the status signal is not detected, it returns to the step 80, and repeats the bit transmitting operation.

When 9 bits of one frame is taken in the shift register 52 and thus the start bit SB appears at the highest ordered stage of the shift register 52, the latch 50 is set at the falling edge of the clock pulse in the clock cycle 9 so that the Q output goes to low level to thereby transmit the low level status signal to the data line 2 (62 of the waveform (c)). Because the received bit counting operation and the status signal transmitting operation are performed with hardware by the shift register 52 and the latch 50 respectively, these operations are shown in Figure 4 as broken line blocks 102 and 106 for distinguishing.

MPU 42 detects the status signal at the sampling of the clock cycle 9. In this case, since MPU 42 detects the status signal in the condition of transmission count=9, or after the completion of transmission of one frame, it indicates correct transmission, and MPU 42 makes the clock line 4 high level following the clock cycle 9 as 64 of the waveform (a) (step 94 in Figure 8). This indicates the positive response.

When the latch 50 is set, the Q output requests interruption to MPU 54 (step 104 in Figure 8). In response to this, MPU 54 samples the clock line 4 in a predetermined time after the interruption, as in the waveform (e), to detect the keyboard response to the status signal (step 108 in Figure 8), and checks whether it is high level (step 110). In this case, the high level is detected, and MPU 54 takes in the scan code A-H of the shift register 52 (step 112) and clears the latch 50 and the shift register 52 (step 114) to make the Q output high level, signalling to keyboard that the keyboard is allowed to transmit the next keyboard data. Then, MPU 54 returns to the program prior to the interruption by the return operation (step 116).

Figure 7B illustrates a case where a noise pulse 66 appears in the clock pulse (a) during the clock cycle 5. Although the noise pulse due to static discharge may occur in either positive or negative polarity, the negative noise pulse 66 during the clock high is illustrated in Fig. 7B.

In this case, the shift register 52 samples data twice during one clock cycle at two falling edges. Therefore, the start bit SB appears at the highest ordered stage of the shift register 52 in clock cycle 8, and returns the low level status signal to the keyboard in clock cycle 8 (70 of the waveform (c)). This status signal is sampled by MPU 42 in clock cycle 8. In this case, since the transmission is not completed because of the transmission count≠9, MPU 42 makes the clock line 2 low level following the clock cycle 8 as 68 of the waveform (a) (step 98 in Figure 8). This indicates the negative response. In a predetermined time after the interruption, MPU 54 samples the clock line 4 to detect this low level. MPU 54 clears the latch 50 and the shift register 52 without taking in the data of the shift register 52 (step 118), returns to the program before the interruption by the return step (step 120), and continues other process until another interruption is caused by the retransmission. MPU 42 prepares for the retransmission (step 100), and retransmits the same scan code after confirming the high level on the data line by the step 78.

The noise pulse due to static discharge has a duration of about 10 - 100 ns, and occurs at time intervals of at least 10 ms according to experience. The intervals are considerably longer than the time required for (the transmission for one frame) plus (the status detection/response/retransmission), and therefore the erroneous transmission is scarcely detected again in the retransmission.

**Claims**

1. Serial keyboard interface system to prevent the erroneous transmission of keyboard data due to noise in a data processing system wherein a keyboard (fig. 5: 6, fig. 1: 10) and a data processing unit (8) are connected through a clock line (4) for transmitting a keyboard clock signal and a data line (2) for transmitting a serial scan code identifying a key, said scan code being transmitted in a frame including a predetermined number of bits and in synchronism with said clock signal, comprising:

counting means (fig. 5: 22, fig. 1: 46) associated with said unit (8) and responsive to said clock signal to advance its count,

means (24, 50) associated with said unit and responsive to said counting means reaching a predetermined state to apply to said data line a status signal indicating the receipt of a number of bits of a frame,

means (16, 26) associated with said keyboard and applying a negative response signal to one of said data (fig. 1) or clock (fig. 5) lines when said status signal is received before all the bits of a frame are transmitted from said keyboard to said data line, and

means (fig. 5: 10, 12, 14; fig. 1: 16, 18 and 24) associated with said keyboard and responsive to said negative response signal to retransmit the same scan code which caused the negative response signal.

2. Serial keyboard interface system according to claim 1,

characterized by a key scan code detection circuit (fig. 1: 12) which receives input signals from the key matrix (10) and connected to a shift register (14), where the scan code is transmitted by clock pulses on a line (20) generated by clock circuit (18), by a counter (24) counting 9 clock pulses on said line (20) and transmitting signals on count outputs 1-8 to a data drive circuit (16) and a signal on the count output 9 to status charge circuit (26) which receives the output of a judge circuit (40) as another input checking at each sample time if the status signal is supplied to a data line (2) from the data processing unit (8).

3. Keyboard interface system according to claims 1 to 2,

characterized in that the status judge circuit (26) is responsive to the count 9 output of the counter (24) and the output of the sample circuit (40) to judge if the status signal is detected in the period of the count 9, and the status judge circuit (26) produces a high level output indicative of positive response on a line (28) when the status signal is detected in the period of the count 9, and when the status signal is not detected in the period of count 9, it produces a low level signal indicative of negative response on a line (30).

4. Keyboard interface system according to claims 1 to 3,

characterized in that in case a noise pulse occurs on a clock line (4) during the transmission of keyboard data, the received bit counting means (22) counts twice in one clock cycle, and generates the received count full signal (RCF) before the completion of receiving of all the bits of one frame, that at said time the status judge circuit (16) does not receive the transmission count full signal (TCF) when receiving the status signal, therefore, it supplies a negative response signal to the clock line (4) through a line (17) and also a control signal through a line (18) to the key scan code transmitting means (10) and the clock means (12) so as to command retransmission of the same scan code, and that in case of a negative response the judging circuit (26) generates a signal to the receiving part (20) through a line (36) to discard the received data in preparation for retransmission.

5. Keyboard interface system according to claim 4, characterized in that the keyboard (6) comprises a key matrix (40), a microprocessor (42), and open collector gates (44 and 46), while the data processing unit (8) comprises an open collector gate (48), a latch (50), a shift register (52), and a microprocessor (54).

**Patentansprüche**

1. Serielles Tastatur-Schnittstellensystem zum Verhindern der fehlerhaften Übertragung von Tastaturdaten aufgrund von Rauschen in einem Datenverarbeitungssystem, bei dem eine Tastatur (Fig. 5: 6, Fig. 1: 10) und eine Datenverarbeitungseinheit (8) durch eine Taktleitung (4) zum Übertragen eines Tastatur-Taktsignals sowie eine Datenleitung (2) zum Übertragen eines eine Taste identifizierenden seriellen Abtastcodes verbunden sind, wobei der Abtastcode in einem eine bestimmte Anzahl von Bits enthaltendem Rahmen und synchron mit dem Taktsignal übertragen wird, folgendes umfassend:

Zählmittel (Fig. 5: 22, Fig. 1: 46), welche der Einheit (8) zugeordnet sind und durch das Taktsignal zum Weiterzählen beaufschlagt werden,

Mittel (24, 50), die der Einheit zugeordnet sind und bei Erreichen eines bestimmten Status durch die Zählmittel ein Statussignal an die Datenleitung anlegen, welches den Eingang einer Anzahl von Bits eines Rahmens anzeigt,

Mittel (16, 26), die der Tastatur zugeordnet sind und ein negatives Antwortsignal an eine der Daten-(Fig. 1) oder Takt-(Fig. 5)-Leitungen anlegen, wenn das Statussignal vor der Übertragung aller Bits eines Rahmens von der Tastatur zur Datenleitung eingeht, und

Mittel (Fig. 5: 10, 12, 14; Fig. 1: 16, 18 und 24), die der Tastatur zugeordnet sind und nach Eingang des negativen Antwortsignals denselben Abtastcode erneut übertragen, welcher das negative Antwortsignal verursacht hat.

2. Serielles Tastatur-Schnittstellensystem nach Anspruch 1,

gekennzeichnet durch eine Schaltung (Fig. 1: 12), die einen Tastenabtastcode erkennt und Eingangssignale von der Tastenmatrix (10) empfängt sowie mit einem Schieberegister (14) verbunden ist, wo der Abtastcode durch Taktimpulse auf einer durch die Taktschaltung (18) erzeugten Leitung (20) übertragen wird, sowie durch einen Zähler (24), der neun Taktimpulse auf der Leitung (20) zählt und Signale auf den Zählausgängen 1-8 zu einer Datentreiberschaltung (16) überträgt sowie ein Signal auf dem Zählausgang neun zur Statuserkennungsschaltung (26), welche den Ausgang einer Abtastschaltung (40) als einen weiteren Eingang empfängt, der bei jeder Abtastzeit nachprüft, ob das Statussignal auf eine Datenleitung (2) von der Datenverarbeitungseinheit (8) angelegt wird.

3. Tastatur-Schnittstellensystem nach den Ansprüchen 1 bis 2, dadurch gekennzeichnet,

daß die Statuserkennungsschaltung (26) auf den Zählstand 9-Ausgang des Zählers (24) sowie auf den Ausgang der Abtastschaltung (40) anspricht, um festzustellen, ob das Statussignal während der Zeitspanne des Zählstandes neun festgestellt wird, und daß die Statuserkennungsschaltung (26) einen hohen Ausgang als Hinweis auf eine positive Antwort auf einer Leitung (28) erzeugt, wenn das Statussignal während der Zeitspanne des Zählstandes neun festgestellt wird, und ein niedriges Signal als Hinweis auf eine negative Antwort auf einer Leitung (30), wenn das Statussignal nicht während der Zeitspanne des Zählstandes neun festgestellt wird.

4. Tastatur-Schnittstellensystem nach den Ansprüchen 1 bis 3, dadurch gekennzeichnet,

daß bei Auftreten eines Rauschimpulses auf einer Taktleitung (4) während der Übertragung von Tastaturdaten die Zählmittel (22) für die eingegangenen Bits zweimal in einem Zählzyklus zählen und das Zählstandsprüfsignal (RCF) vor Abschluß der Aufnahme aller Bits eines Rahmens erzeugen, daß zu diesem Zeitpunkt die Statuserkennungsschaltung (26) das Übertragungsprüfsignal (TCF) bei Empfang des Statussignals nicht empfängt und daher durch eine Leitung (17) ein negatives Antwortsignal an die Taktleitung (4) sowie durch eine Leitung (18) ein Steuersignal an die Übertragungsmittel (10) des Tastenabtastcodes und die Takteinheit (12) anlegt, um die erneute Übertragung desselben Abtastcodes aufzurufen, und daß bei einer negativen Antwort die Erkennungsschaltung (26) ein Signal an die Aufnahme (20) durch eine Leitung (36) zum Löschen der empfangenen Daten zur Vorbereitung der nochmaligen Übertragung anlegt.

5. Tastatur-Schnittstellensystem nach Anspruch 4, dadurch gekennzeichnet,

daß die Tastatur (6) eine Tastenmatrix (10), einen Mikroprozessor (42) sowie offene Gates (44 und 46) enthält, während die Datenverarbeitungseinheit (8) ein offenes Gate (48), eine Verriegelungsschaltung (50), ein Schieberegister (52) und einen Mikroprozessor (54) umfasst.

**Revendications**

1. Système d'interface de clavier sériel pour empêcher la transmission erronée de données de clavier due à un bruit dans un système de traitement de données dans lequel un clavier (Fig. 5: 6, Fig. 1: 10) et une unité de traitement de données (8) sont connectés par une ligne d'horloge (4), pour transmettre un signal d'horloge de clavier, et par une ligne de données (2) pour transmettre un code de balayage sériel identifiant une touche, ledit code de balayage étant transmis en un bloc comprenant un nombre prédéterminé de bits et en synchronisme avec ledit signal d'horloge, comprenant:

des moyens de comptage (Fig. 5: 22, Fig. 1: 46) associés à ladite unité (8) et répondant audit signal d'horloge pour avancer leur compte,

des moyens (24, 50) associés à ladite unité et répondant à l'arrivée desdits moyens de comptage à un état prédéterminé pour appliquer à ladite ligne de données un signal d'état indiquant la réception d'un nombre de bits d'un bloc,

des moyens (16, 26) associés audit clavier et appliquant un signal de réponse négative à l'une des dites lignes de données (Fig. 1) ou d'horloge (Fig. 5) lorsque ledit signal d'état est reçu avant que tous les bits d'un bloc soient transmis par ledit clavier à ladite ligne de données, et

des moyens (Fig. 5: 10, 12, 14; Fig. 1: 16, 18 et 24) associés audit clavier et répondant audit signal de réponse négative pour retransmettre le même code de balayage qui a provoqué le signal de réponse négative.

2. Système d'interface de clavier sériel suivant la revendication 1,

caractérisé par un circuit de détection de code de balayage de touche (Fig. 1: 12) qui reçoit des signaux d'entrée venant de la matrice de touches (10) et qui est connecté à un registre à décalage (14), auquel le code de balayage est transmis par des impulsions d'horloge générées sur une ligne (20) par un circuit d'horloge (18), par un compteur (24) qui compte neuf impulsions d'horloge sur ladite ligne (20) et transmet des signaux de sorties de compte 1-8 à un circuit de pilotage de données (16) et un signal de sortie de compte 9 à un circuit de jugement d'état (26) qui reçoit la sortie d'un circuit d'échantillonnage (40) comme autre entrée et vérifie à chaque instant d'échantillonnage si le signal d'état est fourni à une ligne de données (2) par l'unité de traitement de données (8).

3. Système d'interface de clavier suivant les revendications 1 et 2,

caractérisé en ce que le circuit de jugement d'état (26) répond à la sortie de compte 9 du compteur (24) et à la sortie du circuit d'échantillonnage (40) pour juger si le signal d'état est détecté dans la période du compte 9, et le circuit de jugement d'état (26) fournit une sortie à niveau haut indicative d'une réponse positive sur une ligne (28) lorsque le signal d'état est détecté dans la période du compte 9, et lorsque le signal d'état n'est pas détecté dans la période de compte 9, il produit un signal à niveau bas indicatif d'une réponse négative sur une ligne (30).

4. Système d'interface de clavier suivant les revendications 1 à 3,

caractérisé en ce que, dans le cas où une impulsion de bruit se produit sur une ligne d'horloge (4) pendant la transmission de données de clavier, les moyens de comptage de bits reçus (22) comptent deux fois dans un même cycle d'horloge et génèrent le signal de réception de compte complet (RCF) avant la réception complète de tous les bits d'un bloc, en ce que, audit instant, ledit circuit de jugement d'état (16) ne reçoit pas le signal de transmission de compte complet (TCF) lorsqu'il reçoit le signal d'état, et par conséquent il fournit un signal de réponse négative à la ligne d'horloge (4) par l'intermédiaire d'une ligne (17) et également un signal de commande par l'intermédiaire d'une ligne (18) aux moyens de transmission de code de balayage de touche (10) et aux moyens d'horloge (12) de façon à commander la retransmission du même code de balayage, et en ce que, dans le cas d'une réponse négative, le circuit de jugement (26) génère un signal vers la partie de réception (20), par l'intermédiaire d'une ligne (36), pour rejeter les données reçues en préparation à la retransmission.

5. Système d'interface de clavier suivant la revendication 4,

caractérisé en ce que le clavier (6) comprend une matrice de touches (40), un microprocesseur (42) et des portes à collecteur ouvert (44 et 46), tandis que l'unité de traitement de données (8) comprend une porte à collecteur ouvert (48), une bascule (50), un registre à décalage (52) et un microprocesseur (54).

FIG. I

FIG. 2A

FIG. 2B

FIG. 3

FIG. 4A

A

MAKE DATA
LINE HIGH
( POSITIVE
RESPONSE )          116

MAKE CLOCK          118
LINE LOW
FOR 100 μs                    ────────────►    124    INTERRUPTION

126    SAMPLE
DATA LINE
( HIGH LEVEL )

MAKE DATA          120
LINE / CLOCK
LINE HIGH                              128    TAKE IN
RECEIVED DATA

STANDBY UNTIL      122
NEXT DATA                          130    INITIALIZE
TRANSMISSION                              RECEIVE
PARAMETER

132    RETURN

FIG. 4B

D

FIG. 4C

FIG.5

FIG.6

6

# FIG. 7A

# FIG. 7B

FIG.8